# EUROPEAN PATENT SPECIFICATION

(11) **EP 2 200 045 B1**
(45) Date of publication and mention of the grant of the patent: **09.11.2011**
(21) Application number: 09011429.9
(22) Date of filing: 07.09.2009
(51) Int. Cl.: G11C 16/10, G11C 11/56, G06F 12/02

(54) **Method of updating contents of a multibit flash memory**
Verfahren zur Aktualisierung von Inhalten eines Multibit-Flash-Speicher
Méthode de mise à jour d'une mémoire flash multibit

(30) Priority: 22.12.2008 JP 2008325632
(43) Date of publication of application: 23.06.2010
(60) Divisional application: 10190625.3
(73) Proprietor: Kabushiki Kaisha Toshiba, Minato-ku Tokyo 105-8001 (JP)
(72) Inventor: Kanno, Shinichi, Tokyo 105-8001 (JP); Asano, Shigehiro, Tokyo 105-8001 (JP); Kitsunai, Kazuya, Tokyo 105-8001 (JP); Yano, Hirokuni, Tokyo 105-8001 (JP); Hida, Toshikatsu, Tokyo 105-8001 (JP)
(74) Representative: HOFFMANN EITLE

(56) References cited:
- EP-A- 1 898 312
- WO-A-2006/120686
- US-A- 5 937 425
- US-A1- 2004 268 063

## Description

### CROSS-REFERENCE TO RELATED APPLICATIONS

This application is based upon and claims the benefit of priority from the prior Japanese Patent Application No. 2008-325632, filed on Dec. 22, 2008; the entire contents of which are incorporated herein by reference.

### BACKGROUND OF THE INVENTION

### 1. Field of the Invention

The present invention relates to storage control of a semiconductor storage device.

### 2. Description of the Related Art

In a semiconductor storage device incorporating a NAND flash ROM or the like, previously stored data needs to be securely protected so that it would not be corrupted when power supply is suddenly cut off during a data write operation and results in write failure. A NAND flash ROM of a multiple-level-cell (MLC) type, which stores therein multiple bits in accordance with different voltages, has a mode of writing information into a memory cell one bit at a time by performing the writing several times. There is a problem in this write mode that previously stored information may be lost if power supply is cut off when information is being added into a memory cell having information therein.

To solve this problem, JP-A 2006-221743 (KOKAI) suggests a technology of managing the relationship of pages in blocks that share memory cells and controlling a write operation to write data into a memory cell of each block a single time. In this manner, the externally supplied data can be temporarily stored, and the temporarily stored data is copied to another block at a specific timing. Data corruption can be thereby avoided.

More specifically, an MLC NAND flash ROM is temporarily used as a SLC (two-state) NAND flash ROM so that data for which the write operation is completed is protected from being corrupted. Then, the temporarily stored data is copied to another block with a regular writing method. This realizes a secure data write operation of the MLC NAND flash ROM. With this method, even if power supply is suddenly cut off when the temporarily stored data is being copied to another block, the stored original data would not be corrupted and therefore the data can be easily restored.

According to the technology of JP-A 2006-221743 (KOKAI), however, the amount of data that can be written in a block after one erasure is reduced to "1/the number of writable bits in a memory cell". This means that, to write a certain amount of data into the MLC NAND flash ROM, the amount of to-be-written data multiplied by the number of writable bits in a memory cell has to be erased. Furthermore, according to this technology, the temporarily stored data is always copied to another block. This means that, at the end, the amount of data multiplied by "(the number of writable bits in a memory cell)+1" needs to be erased.

For example, when an MLC NAND flash ROM in which two bits can be written in every memory cell is adopted in this system, data that is 2+1=3 times the amount of to-be-written data needs to be erased, which is a highly unnecessary amount. Furthermore, considering that the number of rewrites is limited, the number of data erasures should be minimized.

Furthermore, EP 1 898 312 A1 discloses that an invalid physical block is searched in ascending order from an address selected at random and a firstly searched invalid physical block is set to be a physical block to be written. The invalid block is already erased or which is needless even though data is written in the block. This document discloses the preamble of claims 1 and 10.

Furthermore, US 5,937,425 A discloses that the desired physical unit is located, the physical block corresponding to the specified block offset is located within that physical unit and if the block is unwritten, the data is written to the block.

This document discloses the preamble of claim 8.

Furthermore, US 2004/268063 A1 discloses a method of managing a page-based memory so as to prevent the corruption of data in previously written pages by an interrupted write operation, if any of the other pages in that risk zone does in fact store valid data, then the selected page is not written. The flash management system seeks a different page for that write operation. The risk zone is a page that could be corrupted by interrupted writes.

### SUMMARY OF THE INVENTION

According to one aspect of the present invention, a multibit NAND Flash memory device is provided as set out in Claim 1_{.}

According to another aspect of the present invention, a multibit NANO Flash memory device is provided as set out in Claim 8.

According to still another aspect of the present invention, a storage controlling method is provided as set out in Claim 10.

### BRIEF DESCRIPTION OF THE DRAWINGS

Fig. 1 is a block diagram of a semiconductor storage device according to a first embodiment;
Fig. 2 is a diagram for explaining the structure of an MLC NAND flash ROM;
Fig. 3 is a diagram illustrating a block management list;
Fig. 4 is a diagram for explaining an address converting method;
Fig. 5 is a diagram for explaining a judging method according to the first embodiment;
Fig. 6 is a diagram for explaining a data moving method according to the first embodiment;
Fig. 7 is a diagram for also explaining the data moving method according to the first embodiment;
Fig. 8 is a flowchart of the procedure of writing new data into the NAND flash ROM according to the first embodiment;
Fig. 9 is a flowchart of the procedure of writing new data into the NAND flash ROM according to a modified example;
Fig. 10 is a block diagram of a semiconductor storage device according to a second embodiment;
Fig. 11 is a diagram illustrating a block memory management list according to the second embodiment;
Fig. 12 is a diagram for explaining a judging method according to the second embodiment; and
Fig. 13 is a flowchart of the procedure of writing new data into the NAND flash ROM according to the second embodiment.

### DETAILED DESCRIPTION OF THE INVENTION

Exemplary examples of a semiconductor storage device and a method of controlling the semiconductor storage device according to the present invention are explained in detail below with reference to the attached drawings.

### (First Embodiment)

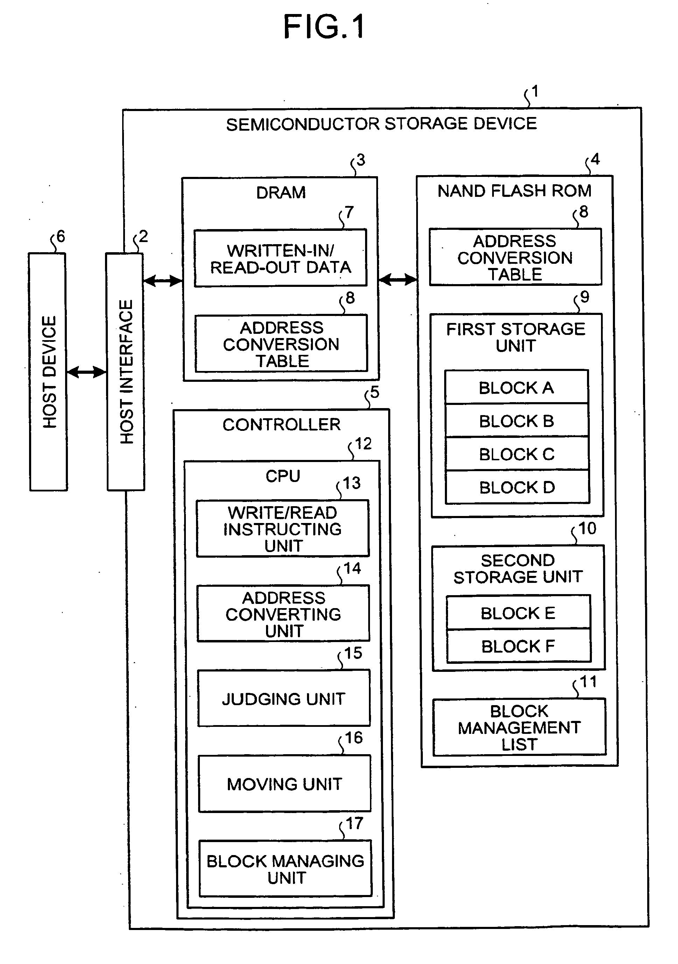

As illustrated in Fig. 1, a semiconductor storage device 1 according to the first embodiment stores data therein, and includes a host interface 2, a dynamic random access memory (DRAM) 3, a NAND flash read only memory (ROM) 4, and a controller 5. The host interface 2 performs data communications with a host device 6, such as a personal computer, to transmit and receive data.

The DRAM 3 is a memory that temporarily stores therein written data that is supplied by the host device 6, and written-in/read-out data 7 that is read from the NAND flash ROM 4 during operation. The DRAM 3 also temporarily stores therein an address conversion table 8 that is read from the NAND flash ROM 4 during operation. The address conversion table 8 will be discussed in detail later when the NAND flash ROM 4 is explained.

The NAND flash ROM 4 is of an MLC type and stores therein the data that is supplied by the host device 6 and temporarily stored in the DRAM 3. The NAND flash ROM 4 includes the address conversion table 8, a first storage unit 9, a second storage unit 10, and a block management list 11.

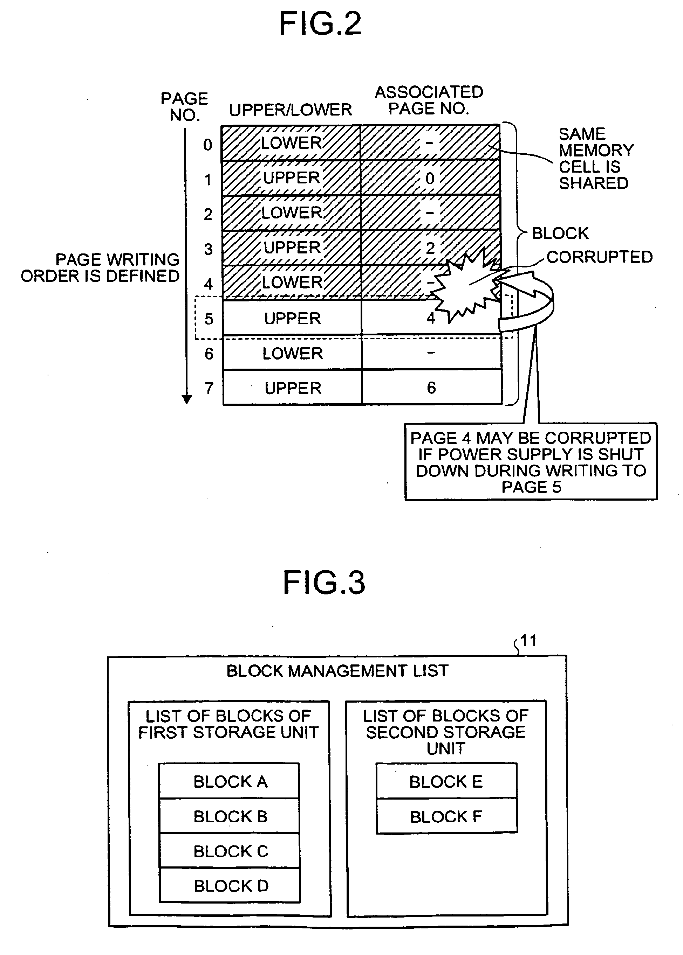

The structure of an ordinary MLC NAND flash ROM and problems residing in the structure are explained with reference to Fig. 2. It is assumed in Fig. 2 that the NAND flash ROM stores two bits in every memory cell.

A NAND flash ROM is divided into blocks, which are unit areas for an erasing operation. Each block is further divided into pages, which are unit areas for a writing/reading operation, and each page is associated with one of the bits of the memory cells in order. In the example of Fig. 2, a block includes 8 pages, pages 0 to 7. The order of data writing into the pages is defined as pages 0, 1, 2, ...7. In this drawing, data is now stored up to page 4.

In general, a page corresponding to the first written bit in a memory cell is referred to as a lower page, and a page corresponding to the second written bit in the same memory cell is referred to as an upper page. Thus, in the lower and upper pages sharing the same memory cell of the NAND flash ROM, data cannot be written into the upper page unless the writing to the lower page is completed. In this example, each pair of pages 0 and 1, 2 and 3, 4 and 5, and 6 and 7 share a memory cell.

In the NAND flash ROM of such a structure, if power supply is shut off during data writing to the upper page, data that is already written into the lower page of the same memory cell is also corrupted. On the other hand, if power supply is shut off during data writing to the lower page, data written in different cells (lower and upper pages thereof) would not be corrupted.

In other words, it is only when data is being written into an upper page that a problem that data written in a lower page of the same memory cell is corrupted and lost occurs. In the example of Fig. 2, if power supply is shut off during data writing to page 5 (upper page), data stored in page 4 (lower page) of the same memory cell is corrupted together.

This problem occurs similarly to all the pages of a memory cell if the lower page and the upper page of the memory cell include more pages.

The same problem could arise in the NAND flash ROM 4 according to the present embodiment. The address conversion table 8, the first storage unit 9, the second storage unit 10, and the block management list 11 basically have the same structure. The present embodiment aims to prevent such a problem from occurring.

The address conversion table 8 indicates the page position (address) of a block of the NAND flash ROM 4 in which the data supplied by the host device 6 is stored. The address conversion table 8 therefore stores therein the position (address) of the NAND flash ROM 4 at which the data supplied by the host device 6 is stored for each page. Here, the data in a page whose address is stored in the address conversion table 8, or in other words the data designated by the address conversion table 8, is referred to as valid data. On the other hand, the data in a page whose address is not stored in the address conversion table 8, or in other words data that is stored but not designated by the address conversion table 8, is referred to as invalid data.

The address conversion table 8 is present only in the NAND flash ROM 4 when the semiconductor storage device 1 is not operating. However, when the host device 6 issues a data write/read instruction to the semiconductor storage device 1, the address conversion table 8 is read from the NAND flash ROM 4 and temporarily stored in the DRAM 3. Then, an address converting unit 14 of the controller 5 that is described later performs an address updating process onto the address conversion table 8 that is temporarily stored in the DRAM 3. The address updating process for the address conversion table 8 in the NAND flash ROM 4 is performed at any given timing, such as when the semiconductor storage device 1 stops its operation.

The first storage unit 9 and the second storage unit 10 each include multiple blocks, as mentioned earlier. In each block, the data supplied by the host device 6 and temporarily stored in the DRAM 3 is written. When actually writing the data, a write/read instructing unit 13 of the controller 5 that is described later selects a block from the blocks of the first storage unit 9 and the second storage unit 10. In Fig. 1, the first storage unit 9 includes four blocks, A to D, and the second storage unit 10 includes two blocks, E and F.

All the data supplied by the host device 6 and temporarily stored in the DRAM 3 is first written in the blocks of the first storage unit 9 (first blocks). On the other hand, only data that is designated by a moving unit 16 of the controller 5 described later is moved from the blocks of the first storage unit 9 and written in the blocks of the second storage unit 10 (second blocks) when there is no writable block in the first storage unit 9.

It should be noted that the blocks of the first storage unit 9 and those of the second storage unit 10 are not fixed, but can be dynamically changed by a block managing unit 17 of the controller 5 that is described later.

The block management list 11 manages the blocks of the first storage unit 9 and the blocks of the second storage unit 10, as illustrated in Fig. 3. In this drawing, four blocks, A to D, belong to the first storage unit 9, and two blocks, E and F, belong to the second storage unit 10.

The block management list 11 is present only in the NAND flash ROM 4. However, the structure may be configured such that the block management list 11 is read from the NAND flash ROM 4 and temporarily stored in the DRAM 3 when the host device 6 issues a data write/read instruction to the semiconductor storage device 1. In such a structure, the block management list 11 that is temporarily stored in the DRAM 3 should be updated by the later-described block managing unit 17 of the controller 5, while the block management list 11 in the NAND flash ROM 4 should be updated at any given timing such as when the semiconductor storage device 1 is shut down.

The controller 5 controls the operation of the semiconductor storage device 1. The controller 5 includes a CPU 12, and controls the semiconductor storage device 1 in accordance with instructions executed by the CPU 12. The CPU 12 includes the write/read instructing unit 13, the address converting unit 14, a judging unit 15, the moving unit 16, and the block managing unit 17. In reality, a program executed by the CPU 12 has a module structure including the write/read instructing unit 13, the address converting unit 14, the judging unit 15, the moving unit 16, and the block managing unit 17. When the CPU 12 reads the program from the ROM or the like (not shown) and executes it, the write/read' instructing unit 13, the address converting unit 14, the judging unit 15, the moving unit 16, and the block managing unit 17 are generated on the CPU 12.

In response to a request from the host device 6, the write/read instructing unit 13 issues a data write instruction to write data of the DRAM 3 to the NAND flash ROM 4 (the blocks of the first storage unit 9 designated by the judging unit 1,5), or a data read instruction to read data from the NAND flash ROM 4 (the blocks of the first storage unit 9 or the second storage unit 10) to the DRAM 3.

The address converting unit 14 converts an external address of the data supplied by the host device 6 to a page of the block of the NAND flash ROM 4 in which the data is actually stored. More specifically, when the data supplied by the host device 6 is stored in the NAND flash ROM 4, the address converting unit 14 associates the external address of the data with the page of the block where the data is stored, and stores it in the address conversion table 8. When a read request is received from the host device 6, the address converting.unit 14 converts the external address to the corresponding page of the block. In other words, the address conversion is performed for individual pages.

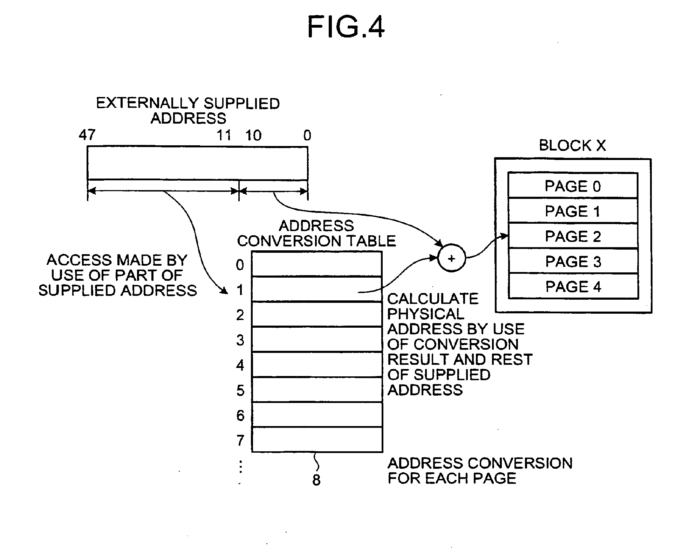

As illustrated in Fig. 4, the address converting unit 14 converts the external address of the data supplied by the host device 6 to a page of a block in the NAND flash ROM 4 with reference to the address conversion table 8. In particular, in the conversion conducted by the address converting unit 14, some highest bits of the external address supplied by the host device 6 are converted to the page of the block of the NAND flash ROM 4, and the remaining lower bits are converted to the data position within the page.

According to Fig. 4, the address supplied from the external address has 48 bits. Of the external address, the upper 37 bits are used for the conversion to the page of the block, while the lower 11 bits are used for the conversion to the data position of the page. 'The numbers of bits vary in accordance with the capacity of a page. The data on the page position of the block in the NAND flash ROM 4 stored in the address conversion table 8 is valid data stored in association with individual external addresses, and thus this data is not allowed to be corrupted.

In a semiconductor storage device incorporating a NAND flash ROM, an erase operation is required before writing into the NAND flash ROM. Furthermore, frequent rewriting only in a certain area of the NAND flash ROM would shorten the life of the ROM. For these reasons, an address converting unit is generally provided in such a device to store data of external addresses supplied by the host device in arbitrary blocks and pages.

When a data write request is received from the host device 6, the judging unit 15 judges whether there is any block in the first storage unit 9 that does not store therein valid data, and identifies such a block. More specifically, the judging unit 15 identifies, from the blocks of the first storage unit 9, a block that does not store therein data designated by the address conversion table 8 (valid data). Then, the write/read instructing unit 13 writes the data received from the host device 6 into the identified block.

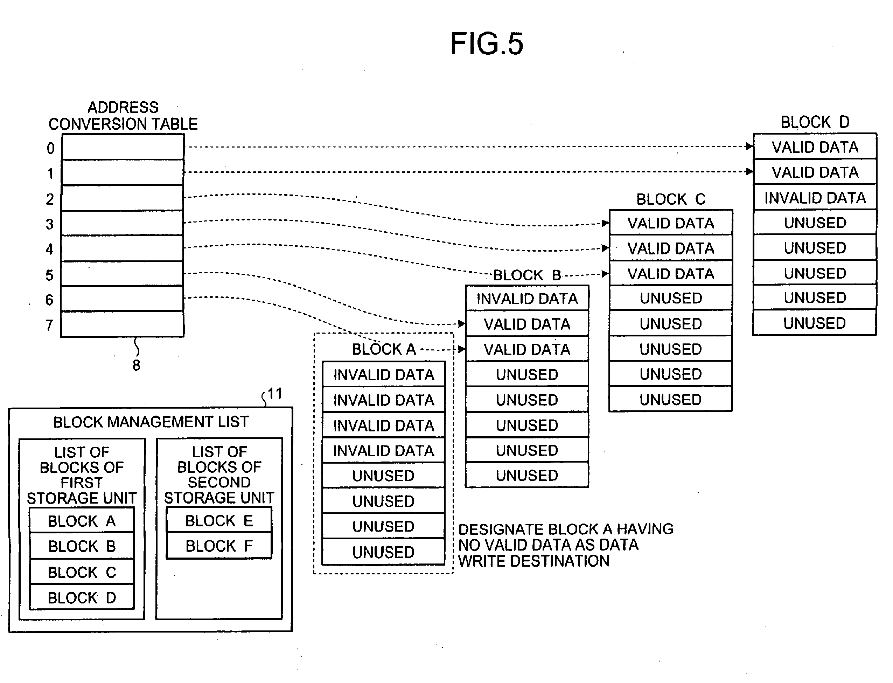

The judging method adopted by the judging unit 15 is explained below with reference to Fig. 5. In this drawing, blocks A to D belong to the first storage unit 9. Among the blocks A to D, the block A is the only one that does not store therein any valid data, or in other words, data designated by the address conversion table 8. The judging unit 15 therefore identifies block A.

When a data write request is received from the host device 6 and when the first storage unit 9 includes no block that does not store therein valid data, or in other words, when all the blocks of the first storage unit 9 store therein at least one item of valid data, the moving unit 16 moves the valid data stored in the blocks of the first storage unit 9 to a block of the second storage unit 10. More specifically, the moving unit 16 reads the valid data stored in the blocks of the first storage unit 9 temporarily to the DRAM 3, and writes the data into a block of the second storage unit 10 at a time.

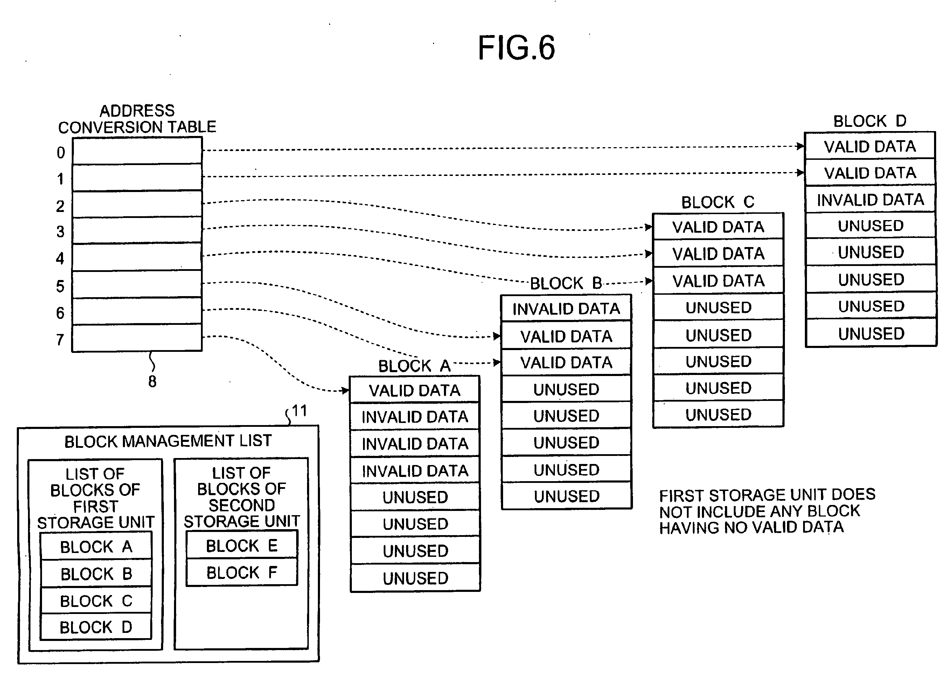

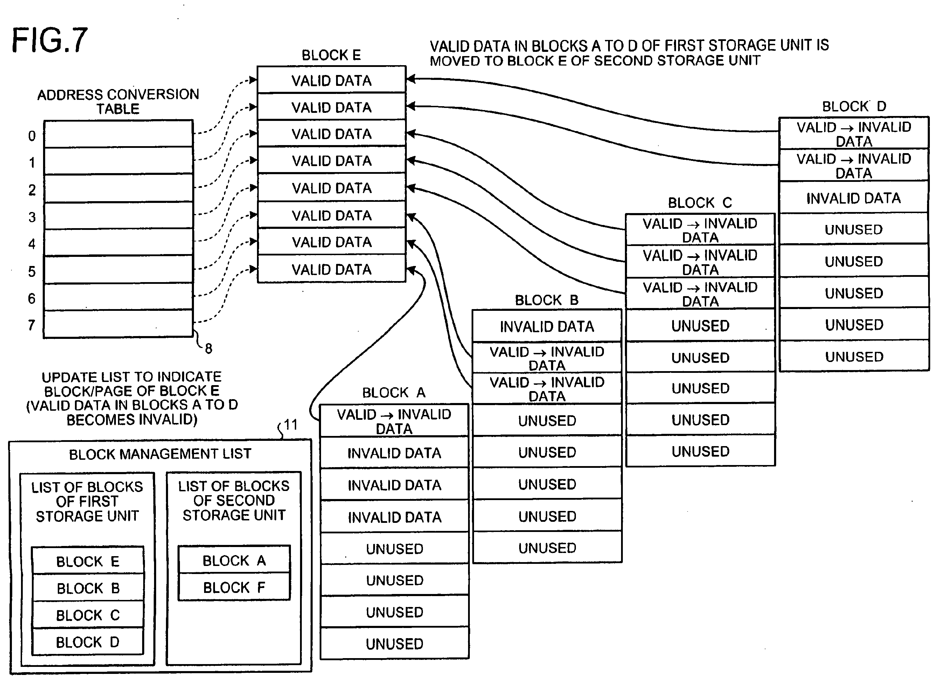

The data moving method adopted by the moving unit 16 is explained below with reference to Figs. 6 and 7. Fig. 6 is a diagram for showing the data before being moved by the moving unit 16, and Fig. 7 is a diagram for showing the data after being moved by the moving unit 16. In Fig. 6, at least one valid data item is stored in each of blocks A to D of the first storage unit 9. Thus, the moving unit 16 moves the valid data stored in blocks A to D to block E of the second storage unit 10, as illustrated in Fig. 7. After the moving unit 16 moves the data, the address converting unit 14 updates the positions of the data items in the address conversion table 8 to indicate the positions to which the data items are moved. Accordingly, all the valid data items stored in blocks A to D are changed to invalid data items.

The block managing unit 17 manages the block management list 11, or in other words the blocks of the first storage unit 9 and the second storage unit 10. As described before, the blocks of the first storage unit 9 are used for writing in the data supplied by the host device 6, while the blocks of the second storage unit 10 are used only when the data is moved by the moving unit 16.

After the moving unit 16 moves the data stored in the blocks of the first storage unit 9 to a block of the second storage unit 10, the block managing unit 17 updates the block management list 11 so that, after the data stored in the blocks of the first storage unit 9 is moved to the block of the second storage unit 10, this block of the second storage unit 10 to which the data is moved from the blocks of the first storage unit 9 is moved to the first storage unit 9, and one of the blocks of the first storage unit 9 is moved to the second storage unit 10. It is assumed here that the block of the first storage unit 9 that is moved to the second storage unit 10 stores no valid data therein after the data is moved to the second storage unit 10.

From Figs. 6 and 7, it can be seen that block E that belongs to the second storage unit 10 in the block management list 11 before the data move in Fig. 6 is moved to the first storage unit 9 after the data move in Fig. 7, and that block A that belongs to the first storage unit 9 before the data move is moved to the second storage unit 10. In this.example, block A that has the least unused pages among blocks A to D in which no valid data is currently stored is moved to the second storage unit 10. This is because an erasing process is performed in the second storage unit 10 on all the pages of each block whether the pages are used or unused, and therefore unnecessary operations can be eliminated by moving a block with the least unused pages to the second storage unit 10.

Then, the moving unit 16 and the block managing unit 17 move all the valid data in blocks A to D of the first storage unit 9 to block E so that data can be written into blocks B to D but not into block A, which has been moved to the second storage unit 10.

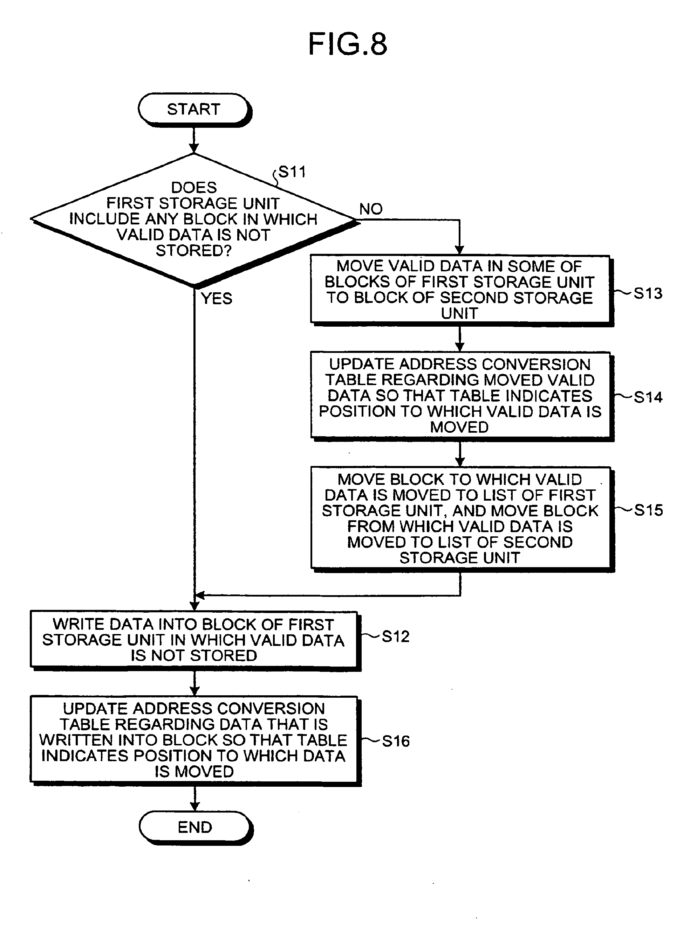

Next, the method of writing new data into the NAND flash ROM 4 of the semiconductor storage device 1 according to the present embodiment is explained with reference to Fig. 8. When the semiconductor storage device 1 receives a data write instruction from the host device 6, the to-be-written data that is supplied by the host device 6 is temporarily stored in the DRAM 3.

Then, the judging unit 15 judges whether the first storage unit 9 includes any block that does not store therein valid data (step S11). More specifically, the judging unit 15 judges whether there is any block that does not store therein data designated by the address conversion table 8 (valid data), among the blocks of the first storage unit 9.

When the judging unit 15 judges that the first storage unit 9 includes a block that does not store therein valid data (Yes at step S11), the judging unit 15 identifies this block. The write/read instructing unit 13 issues an instruction to write data into the block of the first storage unit 9 that does not store therein valid data (step S12). The data is thereby written into the block.

On the other hand, when the judging unit 15 judges that there is no block in the first storage unit 9 that does not store therein valid data (No at step S11), the moving unit 16 moves the valid data in some of the blocks in the first storage unit 9 to a block of the second storage unit 10 (step S13). It is preferable that all the valid data in the blocks be moved so that no valid data remains in these blocks after the moving. When the second storage unit 10 includes more than one block, the valid data may be moved to multiple blocks at a time. It is preferable, however, that the valid data items are dealt with for each block at a time.

As mentioned before, the moving unit 16 first reads the valid data stored in the blocks of the NAND flash ROM 4 to the DRAM 3, and then writes it to another block of the NAND flash ROM 4. However, if valid data has been read from the NAND flash ROM 4 and temporarily stored in the DRAM 3 in response to a read instruction previously issued from the host device 6 before the current write instruction, this data may be directly written in. In this situation, time required to read the valid data in the blocks of the NAND flash ROM 4 into the DRAM 3 can be saved.

Next, the address converting unit 14 updates the address conversion table 8 regarding the valid data moved to the block of the second storage unit 10 so that it indicates the position to which the valid data is moved (block/page position of the second storage unit 10) (step S14).

Then, the block managing unit 17 moves the block of the second storage unit 10 to which the valid data is moved to the list of the first storage unit 9, and moves a no-valid-data block of the first storage unit 9 from which the valid data is moved to the list of the second storage unit 10 (step S15.). Any number of blocks can be moved at this step.

Thereafter, the write/read instructing unit 13 issues an instruction to write the data into a block of the first storage unit 9 in which no valid data is stored (a block from which the valid data is moved) at step S12, and thereby the data is written into the block.

Finally, the address converting unit 14 updates the address conversion table 8 regarding the data written into the block in such a manner that the table indicates the position to which the data is moved (block/page position of the first storage unit 9) (step S16). After the above steps, the operation of writing the new data into the NAND flash ROM 4 is completed.

At step S12, when the first storage unit 9 includes more than one block that stores therein no valid data, the write/read instructing unit 13 needs to select one of the blocks. If a block with the least unused pages in which no data is written is selected, or in other words, if a block having the largest amount of written-in data, blocks with the most unused pages remain. Then, even when a request of writing data of a large size spanning several pages is received thereafter, data can be written in without performing an erasing operation. Hence, the number of erasures can be reduced, which increases the life of the semiconductor storage device 1 (NAND flash ROM 4). It should be noted that the selecting method is not limited to the above but a block may be arbitrarily selected.

In the semiconductor storage device according to the first embodiment, when the judging unit judges that any of the blocks in the first storage unit stores therein no data that is associated with an external address, new data that is externally supplied can be written in a block that does not store therein any data associated with an external address. Hence, the number of data erasures can be reduced, while valid data previously stored in the very block in which the new data is to be written can be prevented from being corrupted and becoming unreadable. The data write speed can also be improved.

Furthermore, in the semiconductor storage device according to the first embodiment, when the judging unit judges that all the blocks of the first storage unit store therein some data associated with external addresses, the moving unit moves the data that is associated with the external addresses and stored in the blocks of the first storage unit to the blocks of the second storage unit so that externally supplied data can be newly written in the blocks from which the data associated with the external addresses is moved. Thus, while the number of data erasures is reduced, the valid data previously stored in the blocks into which the new data is to be written is prevented from being corrupted and becoming unreadable, and the data writing speed is increased.

In the semiconductor storage device 1 according to the present embodiment, when receiving a data write request from the host device 6, the judging unit 15 judges whether the first storage unit 9 includes any block in which no valid data is stored, and identifies such a block if any. However, the moving unit 16 would not move any valid data until there is no more block.in the first storage unit 9 that stores therein no valid data. For this reason, once the judging unit 15 judges that there is no block that does not store therein valid data, the process from the start of the data write request to the end takes very long.

In contrast, a modified example is configured in such a manner that, upon a data write request from the host device 6, the judging unit 15 judges whether the total amount of valid data stored in the blocks of the first storage unit 9 exceeds the amount of data corresponding to one block, and identifies such blocks. Then, every time the total amount of valid data becomes an amount corresponding to one block, the moving unit 16 moves the valid data stored in the blocks of the first storage unit 9 to a block of the second storage unit 10. The time required from the start of the data write request to the end can thereby be averaged out (a situation requiring the longest time can be improved).

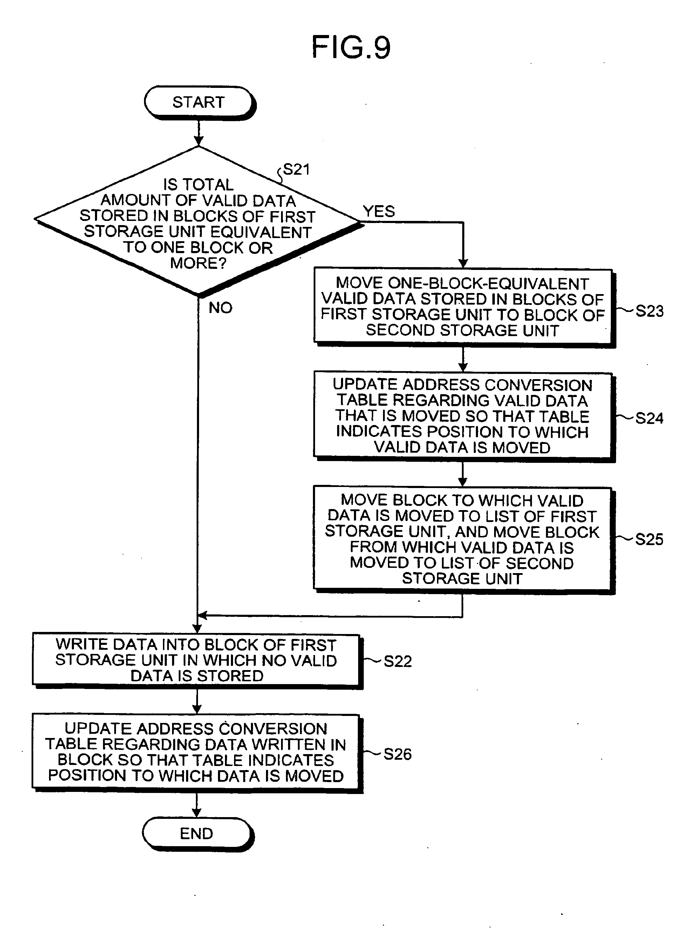

In this modified example, when the host device 6 issues a data write instruction to the semiconductor storage device 1, the judging unit 15 judges whether the total amount of valid data stored in the blocks of the first storage unit 9 is equal to or larger than the amount of data corresponding to one block (step S21), as illustrated in Fig. 9. More specifically, the judging unit 15 judges whether the total amount of data designated by the address conversion table 8 (valid data) in the blocks of the first storage unit 9 is equal to or larger than the amount of data corresponding to one block.

When the judging unit 15 judges that the total amount of valid data stored in the blocks of the first storage unit 9 is not larger than the amount of data corresponding to one block (No at step S21), the judging unit 15 identifies a block in the first storage unit 9 that does not store any valid data therein. Then, the write/read instructing unit 13 issues a instruction of writing data into the block in the first storage unit 9 that does not store valid data therein (step S22), and the data is written into this block. It is assumed here that, when the total amount of valid data stored in the blocks of the first storage unit 9 does not reach the amount of data corresponding to one block, the first storage unit 9 always includes a block that stores no valid data therein.

On the other hand, when the judging unit 15 judges that the total amount of valid data stored in the blocks of the first storage unit 9 is equal to or larger than the amount of data corresponding to one block (Yes at step S21), the moving unit 16 moves the valid data stored in some of the blocks of the first storage unit 9, which is equivalent to one block, to a block of the second storage unit 10 (step S23). The operations at the following steps S24 to S26 are the same as steps S14 to S16 of Fig. 8, and thus the explanation thereof is omitted.

In this modified example, whether the moving unit 16 moves data is determined, based on the judgment as to whether the total amount of valid data stored in the blocks of the first storage unit 9 is equal to or larger than the amount of data equivalent to one block. However, the judgment may be based on as to whether the valid data is equal to or larger than a data amount equivalent to n blocks (where n is a positive integer).

In the semiconductor storage device according to the modified example of the first embodiment, when the judging unit judges that the total amount of data that is associated with external addresses and stored in the blocks of the first storage unit does not reach a certain amount of data, externally supplied data can be newly written into a block that does not store therein any data associated with external addresses. Thus, while reducing the number of data erasures, the valid data previously stored in the block to which the new data is written in is prevented from being corrupted and becoming unreadable. The data writing speed can be improved, and the time from the start of the data write request to the end can be averaged out.

### (Second Embodiment)

According to the first embodiment, when the first storage unit has no block that does not store any valid data therein, the valid data of the blocks of the first storage unit is moved to a block of the second storage unit. In contrast, according to a second embodiment, when the first storage unit has no block that does not store therein any valid data that could become lost, the valid data stored in the blocks of the first storage unit is moved to a block of the second storage unit. The structure of the semiconductor storage device according to the present embodiment is explained, focusing on differences between the first and second embodiments. The rest of the structure is the same as the first embodiment, and thus the same numerals are given to such portions. The explanation thereof should be referred to the above description and is omitted here.

As explained above with reference to Fig. 2 for the first embodiment, when data is written into an upper page, a problem could arise that the data already written into the lower page of the same memory cell is corrupted and lost. In the example of Fig. 2, if power supply is shut off when data is being written into page 5 (upper page), data stored in page 4 (lower page) that shares the same memory cell can be corrupted.

When the data stored in the lower page (page 4) is invalid data, a write operation would not cause any problem even if it fails, because the data that may become lost is not valid data. Similarly, when a write operation starts from the lower page, a failure of writing would not cause a loss of valid data. This point is featured in the semiconductor storage device according to the present embodiment.

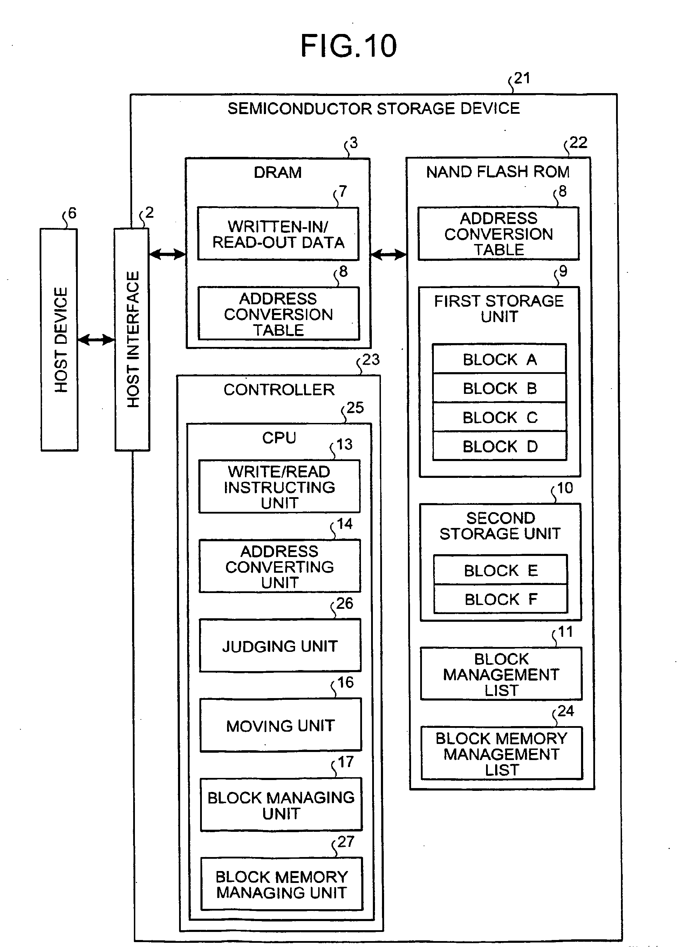

As illustrated in Fig. 10, a semiconductor storage device 21 according to the second embodiment includes the host interface 2, the DRAM 3, a NAND flash ROM 22, and a controller 23. The NAND flash ROM 22 includes the address conversion table 8, the first storage unit 9, the second storage unit 10, the block management list 11, and a block memory management list 24.

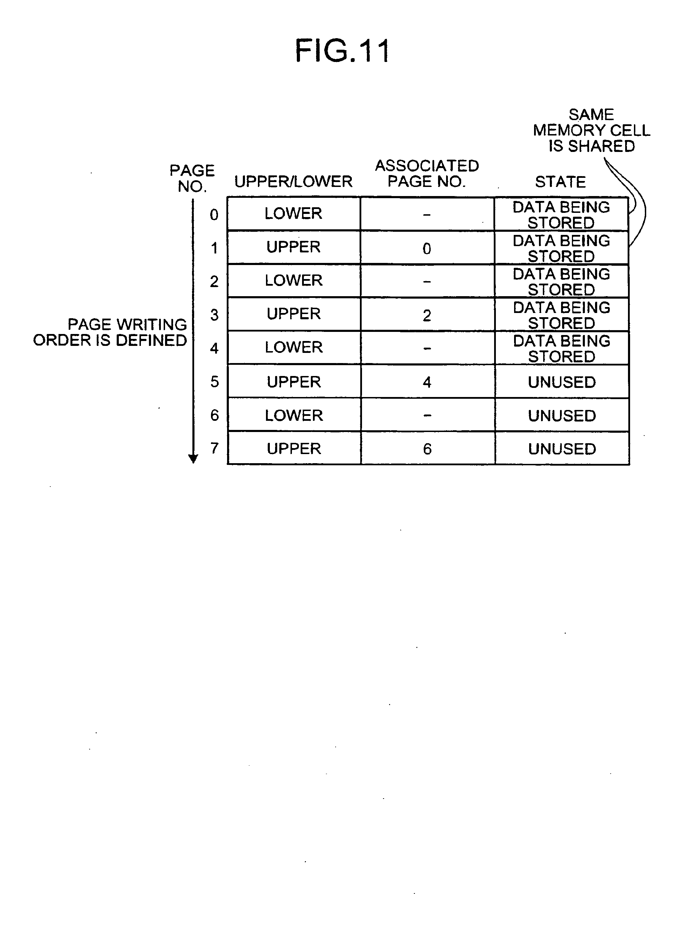

The block memory management list 24 indicates which pages of a block store data therein, as illustrated in Fig. 11. In this drawing; the data has been stored up to page 4 of the block, and page 5 and subsequent pages are unused. The block memory management list 24 stores the memory status for all the blocks of the first storage unit 9 and the second storage unit 10.

The block memory management list 24 is present in the NAND flash ROM 22 only. However, the block memory management list 24 may be configured to be read from the NAND flash ROM 22 and temporarily stored in the DRAM 3 when the host device 6 issues a data write/read instruction to the semiconductor storage device 21. In such a configuration, a later-described block memory managing unit 27 of the controller 23 updates the block memory management list 24 temporarily stored in the DRAM 3. The block memory management list 24 in the NAND flash ROM 22 is updated at any given timing such as when the semiconductor storage device 21 stops its operation.

The controller 23 includes a CPU 25, and controls the semiconductor storage device 21 in accordance with instructions issued by the CPU 25. The CPU 25 includes the write/read instructing unit 13, the address converting unit 14, a judging unit 26, the moving unit 16, the block managing unit 17, and the block memory managing unit 27.

The judging unit 26 judges, when a data write request is received from the host device 6, whether there is a block in which new data writing would not cause loss of valid data, among the blocks of the first storage unit 9, and identifies such a block, if any. More specifically, the judging unit 26 judges, by use of the address conversion table 8 and the block memory management list 24, whether there is any block in which new data writing starts from the upper page and in which the lower page corresponding to this upper page stores therein invalid data, or whether there is any block in which new data writing starts from the lower page. If there is any, the judging unit 26 identifies such a block.

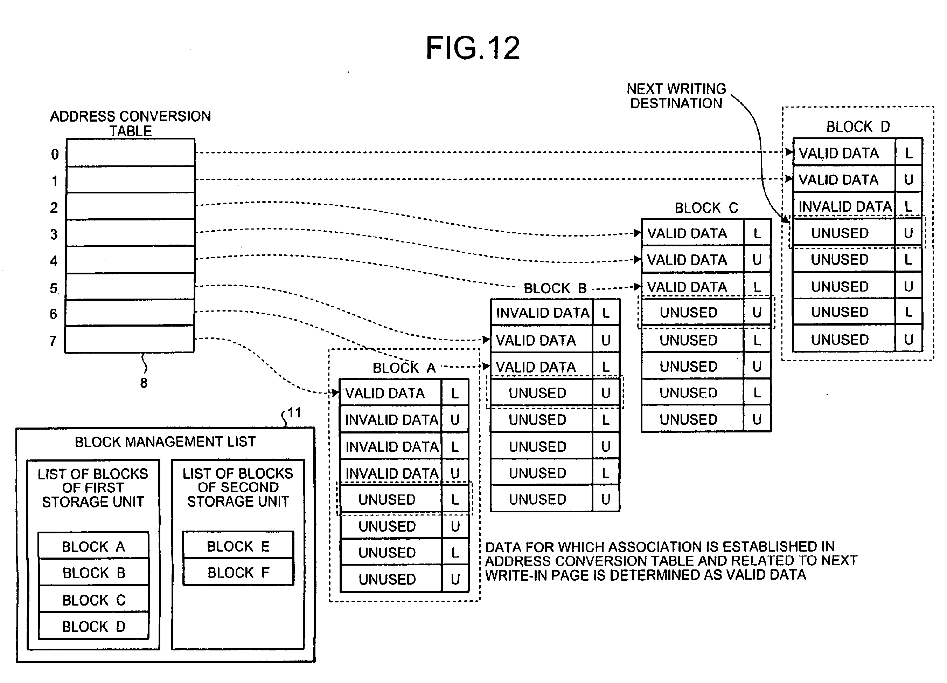

The judging method adopted by the judging unit 26 is now explained with reference to Fig. 12. In this drawing, "L" included in each block designates a lower page, while "U" included in each block designates an upper page. The first storage unit 9 of Fig. 12 includes blocks A to D. Among blocks A to D, new data writing starts from a lower page in block A, and thus this block can be used as a block to write new data. Similarly, new data writing starts from an upper page in block D, and the data stored in the corresponding lower page is invalid. Thus, the block can be used as a block to write new data. In Fig. 12, the judging unit 26 designates block D, but it may designate block A instead.

Then, when a data write request is received from the host device 6 but when the blocks of the first storage unit 9 does not include any block in which new data writing would not cause loss of valid data, the moving unit 16 moves the valid data stored in the blocks of the first storage unit 9 to a block of the second storage unit 10.

The block memory managing unit 27 manages the block memory management list 24, or in other words the memory status of each page in the blocks of the first storage unit 9 and the second storage unit 10.

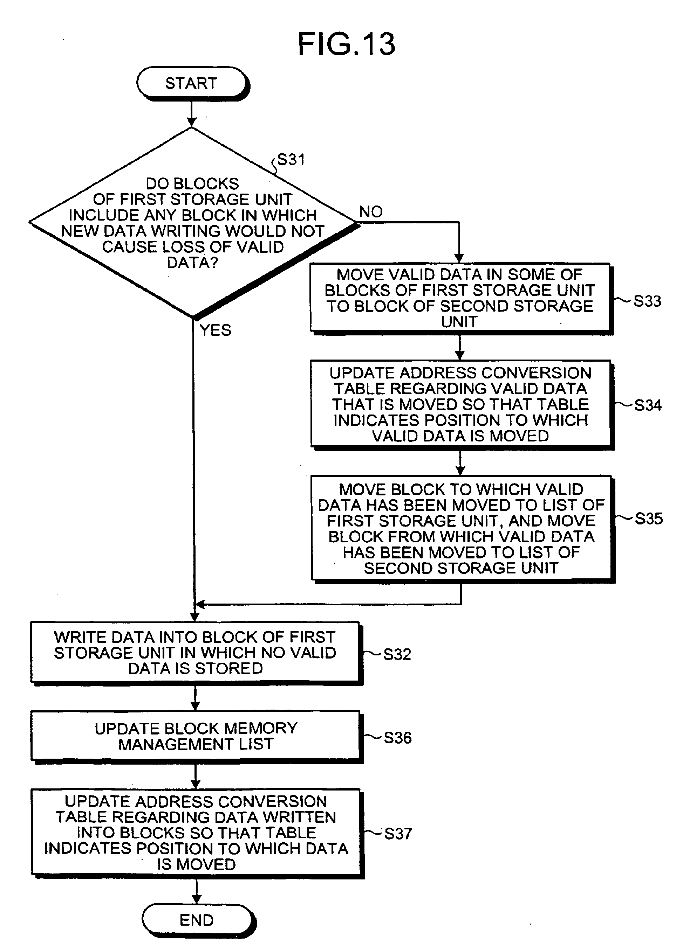

Next, in the semiconductor storage device 21 according to the present embodiment, the method of writing new data into the NAND flash ROM 22 is explained below with reference to Fig. 13. When the host device 6 issues a data write instruction to the semiconductor storage device 21, the to-be-written data supplied by the host device 6 is temporarily stored in the DRAM 3.

Then, the judging unit 26 judges whether the blocks of the first storage unit 9 include any block in which new data writing would not cause loss of valid data (step S31). More specifically, the judging unit 26 judges whether there is any block in which new data writing starts from an upper page and the data stored in the corresponding lower page is invalid data, or whether there is any block in which new data writing starts from a lower page.

When the judging unit 26 judges that the blocks of the first storage unit 9 include a block in which new data writing would not cause loss of valid data (Yes at step S31), the judging unit 26 identifies such a block. The write/read instructing unit 13 issues a data write instruction to write data into the block in the first storage unit 9 in which no valid data is stored (step S32) so that the data write operation is executed onto this block.

On the other hand, when the judging unit 26 judges that the blocks of the first storage unit 9 do not include any block in which new data writing would not cause loss of valid data (No at step S31), the moving unit 16 moves valid data in some of the blocks of the first storage unit 9 to a block of the second storage unit 10 (step S33). At this step, it is preferable that all the valid data in these blocks be moved so that no valid data remains in the blocks after the move. If the second storage unit 10 includes more than one block, the valid data may be moved to multiple blocks at a time. However, it is preferable that items of the to-be-moved valid data be dealt with for each block at a time.

Then, the address converting unit 14 updates the address conversion table 8 regarding the valid data that is moved to the block of the second storage unit 10 so that the address conversion table 8 indicates the position to which the valid data is moved (the block/page position in the second storage unit 10) (step S34).

Next, the block managing unit 17 moves the block of the second storage unit 10 to which the valid data has been moved, to the list of the first storage unit 9, and moves the blocks of the first storage unit 9 from which the valid data has been moved and in which no valid data is currently stored, to the list of the second storage unit 10 (step S35). The number of blocks that are moved here is not limited.

Thereafter, at step 532, the write/read instructing unit 13 issues a data write instruction to write data into a block in the first storage unit 9 in which no valid data is stored (i.e. a block from which valid data is moved), and thereby a data write operation is performed onto this block.

Next, the block memory managing unit 27 updates the block memory management list 24, or in other words the memory status of each page in the blocks of the first storage unit 9 and the second storage unit 10 (step S36).

Finally, the address converting unit 14 updates the address conversion table 8 with respect to the data written into the blocks so that the address conversion table 8 indicates the position to which the data is moved (the block/page position of the first storage unit 9) (step S37). Through the above steps, the process of writing the new data into the NAND flash ROM 22 is completed.

In the semiconductor storage device according to the second embodiment, when the judging unit judges that the first storage unit does not include any block in which data associated with external addresses would not be lost by writing new data, externally supplied data can be newly written into the block in which data associated with external addresses would not be lost. Thus, while the number of data erasures is reduced, the valid data previously stored in the block to which the new data is to be written is prevented from being corrupted and becoming unreadable. Furthermore, the data writing speed can be increased.

In addition, in the semiconductor storage device according to the second embodiment, the judging unit identifies a block in which the valid data would not be lost even if the writing operation fails, as a block for newly writing externally supplied data in. This increases selections of blocks to which the data is written, while the number of data moving by the moving unit can be reduced, thereby increasing the life of rewriting.

Additional advantages and modifications will readily occur to those skilled in the art. Therefore, the invention in its broader aspects is not limited to the specific details and representative embodiments shown and described herein. Accordingly, various modifications may be made without departing from the scope of the general inventive concept as defined by the appended claims and their equivalents.

## Claims

1. A multibit NAND Flash memory device (1), comprising:
a first storage unit (9) that has a plurality of first blocks that are data write regions;
an instructing unit (13) arranged to issue a write instruction of writing data into the first blocks;
a converting unit (14) arranged to convert an external address of input data to a memory position in the first blocks with reference to a conversion table (8) in which external addresses of the data are associated with the memory positions of the data in the first blocks; and
a judging unit (15) arranged to judge whether at least one of the first blocks does not store valid data, the valid data being the data associated with the external addresses having corresponding memory positions stored in the conversion table (8), wherein
the instructing unit (13) is arranged to issue the write instruction of writing the input data into a first block storing no valid data if such a first block exists,
**characterized in that**:
the multibit NAND Flash memory device (1) further include:
a second storage unit (10) that has a plurality of second blocks that are data write regions; and
a moving unit (16) arranged to move the valid data stored in the first blocks to the second blocks if every first block of the first blocks stores valid data,
and wherein the instructing unit (13) is arranged to issue the write instruction of writing the input data into a first block from which the valid data has been moved.

2. The device (1) according to Claim 1, further comprising a managing unit (17) arranged to move the second blocks to which the valid data is moved from the second storage unit (10) to the first storage unit (9), and arranged to move the first blocks from the first storage unit (9) to the second storage unit (10).

3. The device (1) according to Claim 1, wherein
the judging unit (15) is further arranged to judge a total number of items of the valid data stored in the first blocks,
the instructing unit (13) is arranged to issue the write instruction of writing the input data into the first block storing no valid data, when the total number is smaller than a predetermined number,
the moving unit (16) is arranged to move the valid data stored in the first blocks to the second blocks when the total number is equal to or larger than the predetermined number, and
the instructing unit (13) is arranged to issue the write instruction of writing the input data into the first blocks from which the valid data has been moved.

4. The device (1) according to Claim 3, further comprising a managing unit (17) arranged to move the second blocks to which the valid data is moved from the second storage unit (10) to the first storage unit (9), and arranged to move the first blocks from the first storage unit (9) to the second storage unit (10).

5. The device (1) according to Claim 3, wherein the predetermined number is an amount of data equivalent to one block of the first blocks .

6. The device (1) according to Claim 3, wherein the predetermined number is an amount of data equivalent to a plurality of blocks of the first blocks.

7. The device (1) according to Claim 3, wherein the instructing unit (13) is arranged to issue the write instruction of writing the input data into the first block in which the largest amount of data is written, among the first blocks storing no valid data.

8. A multibit NAND Flash memory device (21) comprising:
a first storage unit (9) that has a plurality of first blocks that are data write regions;
an instructing unit (13) arranged to issue a write instruction of writing data into the first blocks;
a converting unit (14) arranged to convert an external address of input data to a memory position in the first blocks with reference to a conversion table (8) in which external addresses of the data are associated with memory positions of the data in the first blocks;
a managing unit (17) arranged to manage a memory status of the data in the first blocks; the multibit NAND Flash memory device being **characterized in that** it further includes
a judging unit (26) that is arranged to judge, based on the memory positions of the input data and the memory status of the data stored in the first blocks, whether the first blocks include a safe first block, the safe first block being a first block in which data writing would start from an upper page and in which a lower page sharing a storage element with the upper page does not store valid data or in which data writing would start from a lower page, the valid data being the data associated with the external addresses having corresponding memory positions stored in the conversion table (8),
wherein:
the instructing unit (13) is arranged to issue the write instruction of, writing the input data into a safe first block if a safe first block exists, y
the multibit NAND Flash memory device (21) further includes :
a second storage unit (10) that has a plurality of second blocks that are data write regions; and
a moving unit (16) arranged to move the valid data stored in the first blocks to the second blocks the first blocks do not include a safe first block,
and wherein the instructing unit (13) issues the write instruction of writing the input data to a first block from which the valid data has been moved.

9. The device (21) according to Claim 8, further comprising a managing unit (17) arranged to move the second blocks to which the valid data is moved from the second storage unit (10) to the first storage unit (9), and arranged to move the first blocks from the first storage unit (9) to the second storage unit (10).

10. A storage controlling method implemented in a multibit NAND Flash memory device (1), the method comprising:
issuing a write instruction of writing data into first blocks that are data write regions in a first storage unit (9) ;
converting an external address of input data to a memory position in the first blocks with reference to a conversion table (8) in which external addresses of the data are associated with the memory positions of the data in the first blocks; and
judging whether at least one of the first blocks does not store valid data, the valid data being the data associated with the external addresses having corresponding memory positions stored in the conversion table (8), wherein
the issuing issues the write instruction of writing the input data into a first block storing no valid data y such a first block exists,
**characterized in that** the method further includes:
moving the valid data stored in the first blocks to the second blocks that are data write regions in a second storage unit (10), y every first block of the first blocks stores valid data,
and wherein the issuing issues the write instruction of writing the input data into a first block from which the valid data has been moved.

## Patentansprüche

1. Mehrbit-NAND-Flash-Speichervorrichtung (1), umfassend:
eine erste Speichereinheit (9), die eine Mehrzahl von ersten Blöcken aufweist, die Datenschreibbereiche sind;
eine Anweisungseinheit (13), die dafür ausgelegt ist, eine Schreibanweisung des Schreibens von Daten in die ersten Blöcke zu erteilen;
eine Umwandlungseinheit (14), die dafür ausgelegt ist, eine externe Adresse von Eingangsdaten in eine Speicherposition in den ersten Blöcken umzuwandeln, unter Bezugnahme auf eine Umwandlungstabelle (8), in der externe Adressen der Daten mit den Speicherpositionen der Daten in den ersten Blöcken assoziiert sind; und
eine Bewertungseinheit (15), die dafür ausgelegt ist, zu bewerten, ob zumindest einer der ersten Blöcke keine gültigen Daten speichert, wobei die gültigen Daten Daten sind, die mit den externen Adressen assoziiert sind, die entsprechende Speicherpositionen aufweisen, die in der Umwandlungstabelle (8) gespeichert sind, wobei
die Anweisungseinheit (13) dafür ausgelegt ist, die Schreibanweisung zum Schreiben der Daten in einen ersten Block, der keine gültige Daten speichert, zu erteilen, falls ein solcher erster Block existiert,
**dadurch gekennzeichnet, dass**:
die Mehrbit-NAND-Flash-Speichervorrichtung (1) weiter beinhaltet:
eine zweite Speichereinheit (10), die eine Mehrzahl von zweiten Blöcken aufweist, die Datenschreibbereiche sind; und
eine Verschiebungseinheit (16), die dafür ausgelegt ist, die in den ersten Blöcken gespeicherten gültigen Daten in die zweiten Blöcke zu schieben, falls jeder erste Block der ersten Blöcke gültige Daten speichert,
und wobei die Anweisungseinheit (13) dafür ausgelegt ist, die Schreibanweisung zum Schreiben der Eingangsdaten in einen ersten Block zu erteilen, aus dem die gültigen Daten verschoben worden sind.

2. Vorrichtung (1) gemäß Anspruch 1, weiter umfassend eine Verwaltungseinheit (17), die dafür ausgelegt ist, die zweiten Blöcke, zu denen die gültigen Daten aus der zweiten Speichereinheit (10) verschoben sind, zur ersten Speichereinheit (9) zu verschieben, und dafür ausgelegt ist, die ersten Blöcke aus der ersten Speichereinheit (9) zur zweiten Speichereinheit (10) zu verschieben.

3. Vorrichtung (1) gemäß Anspruch 1, wobei
die Bewertungseinheit (15) weiter dafür ausgelegt ist, die Gesamtanzahl von Objekten der in den ersten Blöcken gespeicherten gültigen Daten zu bewerten,
die Anweisungseinheit (13) dafür ausgelegt ist, die Schreibanweisung zum Schreiben der Eingangsdaten in den ersten Block, der keine gültigen Daten speichert, zu erteilen, wenn die Gesamtzahl kleiner als eine vorbestimmte Anzahl ist,
die Verschiebungseinheit (16) dafür ausgelegt ist, die in den ersten Blöcken gespeicherten gültigen Daten in die zweiten Blöcke zu verschieben, wenn die Gesamtanzahl gleich oder größer der vorbestimmten Anzahl ist, und
die Anweisungseinheit (13) dafür ausgelegt ist, die Schreibanweisung zum Schreib der Eingangsdaten in die ersten Blöcke, aus denen die gültigen Daten verschoben worden sind, zu erteilen.

4. Vorrichtung (1) gemäß Anspruch 3, weiter umfassend eine Verwaltungseinheit (17), die dafür ausgelegt ist, die zweiten Blöcke, zu denen die gültigen Daten verschoben sind, aus der zweiten Speichereinheit (10) zur ersten Speichereinheit (9) zu verschieben, und dafür ausgelegt ist, die ersten Blöcke aus der ersten Speichereinheit (9) zur zweiten Speichereinheit (10) zu verschieben.

5. Vorrichtung (1) gemäß Anspruch 3, wobei die vorbestimmte Anzahl eine Datenmenge ist, die äquivalent zu einem Block der ersten Blöcke ist.

6. Vorrichtung (1) gemäß Anspruch 3, wobei die vorbestimmte Anzahl eine Datenmenge ist, die äquivalent einer Mehrzahl von Blöcken der ersten Blöcke ist.

7. Vorrichtung (1) gemäß Anspruch 3, wobei die Anweisungseinheit (13) dafür ausgelegt ist, die Schreibanweisung zum Schreiben der Eingangsdaten in den ersten Block, in den die größte Datenmenge geschrieben wird, aus den keine gültigen Daten speichernden ersten Blöcken, zu erteilen.

8. Mehrbit-NAND-Flash-Speichervorrichtung (21), umfassend:
eine erste Speichereinheit (9), die eine Mehrzahl von ersten Blöcken aufweist, die Datenschreibbereiche sind;
eine Anweisungseinheit (13), die dafür ausgelegt ist, eine Schreibanweisung des Schreibens von Daten in die ersten Blöcke zu erteilen;
eine Umwandlungseinheit (14), die dafür ausgelegt ist, eine externe Adresse von Eingangsdaten in eine Speicherposition in den ersten Blöcken umzuwandeln, unter Bezugnahme auf eine Umwandlungstabelle (8), in der externe Adressen der Daten mit den Speicherpositionen der Daten in den ersten Blöcken assoziiert sind; und
eine Verwaltungseinheit (17), die dafür ausgelegt ist, einen Speicherstatus der Daten in den ersten Blöcken zu verwalten;
wobei die Mehrbit-NAND-Flash-Speichervorrichtung **dadurch gekennzeichnet ist, dass** sie weiter beinhaltet
eine Bewertungseinheit (26), die dafür ausgelegt ist, basierend auf den Speicherpositionen der Eingangsdaten und dem Speicherstatus der in den ersten Blöcken gespeicherten Daten zu bewerten, ob die ersten Blöcke einen sicheren ersten Block beinhalten, wobei der sichere erste Block ein erster Block ist, bei dem ein Datenschreiben von einer oberen Seite starten würde, und bei dem eine untere Seite, die ein Speicherelement mit der oberen Seite teilt, keine gültigen Daten speichert, oder bei dem Datenschreiben von einer unteren Seite starten würde, wobei die gültigen Daten die Daten sind, die mit den externen Adressen assoziiert sind, die korrespondierende Speicherpositionen in der Umwandlungstabelle (8) aufweisen,
wobei:
die Anweisungseinheit (13) dafür ausgelegt ist, die Schreibanweisung des Schreibens der Eingangsdaten in einen sicheren ersten Block zu erteilen, falls ein sicherer erster Block existiert,
die Mehrbit-NAND-Flash-Speichervorrichtung (21) weiter beinhaltet:
eine zweite Speichereinheit (10), die eine Mehrzahl von zweiten Blöcken aufweist, die Datenschreibbereiche sind; und
eine Verschiebungseinheit (16), die dafür ausgelegt ist, die gültigen, in den ersten Blöcken gespeicherten Daten zu den zweiten Blöcken zu verschieben, falls die ersten Blöcke keinen sicheren ersten Block beinhalten;
und wobei die Anweisungseinheit (13) die Schreibanweisung zum Schreiben der Eingangsdaten in einen ersten Block erteilt, aus dem die gültigen Daten verschoben worden sind.

9. Vorrichtung (21), gemäß Anspruch 8, weiter umfassend eine Verwaltungseinheit (17), die dafür ausgelegt ist, die zweiten Blöcke, zu denen die gültigen Daten verschoben sind, aus der zweiten Speichereinheit (10) zur ersten Speichereinheit (9) zu verschieben, und ausgelegt ist, die ersten Blöcke aus der ersten Speichereinheit (9) zur zweiten Speichereinheit (10) zu verschieben.

10. Speichersteuerverfahren, das in einer Mehrbit-NAND-Flash-Speichervorrichtung (1) implementiert ist, wobei das Verfahren umfasst:
Erteilen einer Schreibanweisung zum Schreiben von Daten in erste Blöcke, die Datenschreibbereiche in einer ersten Speichereinheit (9) sind;
Umwandeln einer externen Adresse von Eingangsdaten in eine Speicherposition in den ersten Blöcken unter Bezugnahme auf eine Umwandlungstabelle (8), in der externe Adressen der Daten mit den Speicherpositionen der Daten in den ersten Blöcken assoziiert sind; und
Bewerten, ob zumindest einer der ersten Blöcke keine gültigen Daten speichert, wobei die gültigen Daten die Daten sind, die mit den externen Adressen assoziiert sind, die entsprechende, in der Umwandlungstabelle (8) gespeicherten Speicherpositionen aufweisen, wobei
das Erteilen, die Schreibanweisung zum Schreiben der Eingangsdaten in einen ersten Block erteilt, der keine gültigen Daten speichert, falls ein solcher erster Block existiert,
**dadurch gekennzeichnet, dass** das Verfahren weiter beinhaltet:
Verschieben der in den ersten Blöcken gespeicherten gültigen Daten zu den zweiten Blöcken, welche Datenschreibbereiche in einer zweiten Speichereinheit (10) sind, falls jeder erste Block der ersten Blöcke gültige Daten speichert,
und wobei das Erteilen die Schreibanweisung zum Schreiben der Eingangsdaten in einen ersten Block, aus dem die gültigen Daten verschoben worden sind, erteilt.

## Revendications

1. Dispositif de mémoire flash NON-ET multibit (1), comprenant :
une première unité de stockage (9) qui comporte une pluralité de premiers blocs qui sont des régions d'écriture de données ;
une unité d'instruction (13) agencée pour émettre une instruction d'écriture permettant d'écrire des données dans les premiers blocs ;
une unité de conversion (14) agencée pour convertir une adresse externe de données d'entrée en une position de mémoire dans les premiers blocs en se référant à une table de conversion (8) dans laquelle des adresses externes des données sont associées aux positions de mémoire des données dans les premiers blocs ; et
une unité de jugement (15) agencée pour juger si au moins un des premiers blocs ne stocke pas de données valides, les données valides étant les données associées aux adresses externes ayant des positions de mémoire correspondantes stockées dans la table de conversion (8), où
l'unité d'instruction (13) est agencée pour émettre l'instruction d'écriture permettant d'écrire les données d'entrée dans un premier bloc ne stockant pas de données valides si un tel premier bloc existe,
**caractérisé en ce que** :
le dispositif de mémoire flash NON-ET multibit (1) inclut en outre :
une seconde unité de stockage (10) qui comporte une pluralité de seconds blocs qui sont des régions d'écriture de données ; et
une unité de déplacement (16) agencée pour déplacer les données valides stockées dans les premiers blocs vers les seconds blocs si chaque premier bloc des premiers blocs stocke des données valides,
et dans lequel l'unité d'instruction (13) est agencée pour émettre l'instruction d'écriture permettant d'écrire les données d'entrée dans un premier bloc depuis lequel les données valides ont été déplacées.

2. Dispositif (1) selon la revendication 1, comprenant en outre une unité de gestion (17) agencée pour déplacer les seconds blocs vers lesquels les données valides sont déplacées de la seconde unité de stockage (10) à la première unité de stockage (9), et agencée pour déplacer les premiers blocs de la première unité de stockage (9) à la seconde unité de stockage (10).

3. Dispositif (1) selon la revendication 1, dans lequel
l'unité de jugement (15) est en outre agencée pour juger un nombre total d'articles des données valides stockées dans les premiers blocs,
l'unité d'instruction (13) est agencée pour émettre l'instruction d'écriture permettant d'écrire les données d'entrée dans le premier bloc ne stockant pas de données valides, lorsque le nombre total est inférieur à un nombre prédéterminé,
l'unité de déplacement (16) est agencée pour déplacer les données valides stockées dans les premiers blocs vers les secondes blocs lorsque le nombre total est égal ou supérieur au nombre prédéterminé, et
l'unité d'instruction (13) est agencée pour émettre l'instruction d'écriture permettant d'écrire les données d'entrée dans les premiers blocs depuis lesquels les données valides ont été déplacées.

4. Dispositif (1) selon la revendication 3, comprenant en outre une unité de gestion (17) agencée pour déplacer les seconds blocs vers lesquels les données valides sont déplacées de la seconde unité de stockage (10) à la première unité de stockage (9), et agencée pour déplacer les premiers blocs de la première unité de stockage (9) à la seconde unité de stockage (10).

5. Dispositif (1) selon la revendication 3, dans lequel le nombre prédéterminé est une quantité de données équivalente à un bloc des premiers blocs.

6. Dispositif (1) selon la revendication 3, dans lequel le nombre prédéterminé est une quantité de données équivalente à une pluralité de blocs des premiers blocs.

7. Dispositif (1) selon la revendication 3, dans lequel l'unité d'instruction (13) est agencée pour émettre l'instruction d'écriture permettant d'écrire les données d'entrée dans le premier bloc dans lequel la plus grande quantité de données est écrite, parmi les premiers blocs ne stockant pas de données valides.

8. Dispositif de mémoire flash NON-ET multibit (21), comprenant :
une première unité de stockage (9) qui comporte une pluralité de premiers blocs qui sont des régions d'écriture de données ;
une unité d'instruction (13) agencée pour émettre une instruction d'écriture permettant d'écrire des données dans les premiers blocs ;
une unité de conversion (14) agencée pour convertir une adresse externe de données d'entrée en une position de mémoire dans les premiers blocs en se référant à une table de conversion (8) dans laquelle des adresses externes des données sont associées à des positions de mémoire des données dans les premiers blocs ;
une unité de gestion (17) agencée pour gérer un statut de mémoire des données dans les premiers blocs ;
le dispositif de mémoire flash NON-ET multibit (21) étant **caractérisé en ce qu'**il inclut en outre :
une unité de jugement (26) qui est agencée pour juger, sur la base des positions de mémoire des données d'entrée et du statut de mémoire des données stockées dans les premiers blocs, si les premiers blocs incluent un premier bloc sûr, le premier bloc sûr étant un premier bloc dans lequel l'écriture de données commencerait à partir d'une page supérieure et dans lequel une page inférieure partageant un élément de stockage avec la page supérieure ne stocke pas de données valides ou dans lequel l'écriture de données commencerait à partir d'une page inférieure, les données valides étant les données associées aux adresses externes ayant des positions de mémoire correspondantes stockées dans la table de conversion (8),
dans lequel :
l'unité d'instruction (13) est agencée pour émettre l'instruction d'écriture permettant d'écrire les données d'entrée dans un premier bloc sûr si un premier bloc sûr existe,
le dispositif de mémoire flash NON-ET multibit (21) inclut en outre :
une seconde unité de stockage (10) qui comporte une pluralité de seconds blocs qui sont des régions d'écriture de données ; et
une unité de déplacement (16) agencée pour déplacer les données valides stockées dans les premiers blocs vers les seconds blocs si les premiers blocs n'incluent pas un premier bloc sûr,
et dans lequel l'unité d'instruction (13) émet l'instruction d'écriture permettant d'écrire les données d'entrée vers un premier bloc depuis lequel les données valides ont été déplacées.

9. Dispositif (21) selon la revendication 8, comprenant en outre une unité de gestion (17) agencée pour déplacer les seconds blocs vers lesquels les données valides sont déplacées de la seconde unité de stockage (10) à la première unité de stockage (9), et agencée pour déplacer les premiers blocs de la première unité de stockage (9) à la seconde unité de stockage (10).

10. Procédé de contrôle de stockage mis en oeuvre dans un dispositif de mémoire flash NON-ET multibit (1), le procédé comprenant :
l'émission d'une instruction d'écriture permettant d'écrire des données dans des premiers blocs qui sont des régions d'écriture de données dans une première unité de stockage (9) ;
la conversion d'une adresse externe de données d'entrée en une position de mémoire dans les premiers blocs en se référant à une table de conversion (8) dans laquelle des adresses externes des données sont associées aux positions de mémoire des données dans les premiers blocs ; et
le jugement si au moins un des premiers blocs ne stocke pas de données valides, les données valides étant les données associées aux adresses externes ayant des positions de mémoire correspondantes stockées dans la table de conversion (8), où
l'émission émet l'instruction d'écriture permettant d'écrire les données d'entrée dans un premier bloc ne stockant pas de données valides si un tel premier bloc existe,
**caractérisé en ce que** le procédé inclut en outre :
le déplacement des données valides stockées dans les premiers blocs vers les seconds blocs qui sont des régions d'écriture de données dans une seconde unité de stockage (10), si chaque premier bloc des premiers blocs stocke des données valides,
et dans lequel l'émission émet l'instruction d'écriture permettant d'écrire les données d'entrée dans un premier bloc depuis lequel les données valides ont été déplacées.
